(19) Europäisches Patentamt

European Patent Office

Office européen des brevets

(11) **EP 1 312 162 B1**

## (12) EUROPEAN PATENT SPECIFICATION

(45) Date of publication and mention
of the grant of the patent:
**12.01.2005 Bulletin 2005/02**

(21) Application number: **01961076.5**

(22) Date of filing: **14.08.2001**

(51) Int Cl.⁷: **H03G 9/02**, H03G 3/32

(86) International application number:
**PCT/IL2001/000759**

(87) International publication number:
**WO 2002/015395 (21.02.2002 Gazette 2002/08)**

(54) **VOICE ENHANCEMENT SYSTEM**

SYSTEM ZUR ERHÖHUNG DER SPRACHQUALITÄT

SYSTEME D'AMELIORATION DE LA QUALITE DE SIGNAUX VOCAUX

(84) Designated Contracting States:
**AT BE CH CY DE DK ES FI FR GB GR IE IT LI LU
MC NL PT SE TR**

(30) Priority: **14.08.2000 US 224513 P**
**02.10.2000 US 236721 P**

(43) Date of publication of application:
**21.05.2003 Bulletin 2003/21**

(73) Proprietor: **Clear Audio Ltd.**
**54051 Givat Shmuel (IL)**

(72) Inventor: **LICHT, Zvi**
**54051 Givat Shmuel (IL)**

(74) Representative: **Jorritsma, Ruurd et al**
**Nederlandsch Octrooibureau**
**Postbus 29720**
**2502 LS Den Haag (NL)**

(56) References cited:
**EP-A- 0 856 833       US-A- 4 829 565**
**US-A- 5 450 494**

• **PATENT ABSTRACTS OF JAPAN vol. 1997, no.
09, 30 September 1997 (1997-09-30) & JP 09
116362 A (MATSUSHITA ELECTRIC IND CO
LTD), 2 May 1997 (1997-05-02)**

## Description

The present application claims the benefit of U.S. provisional patent applications 60/224,513, filed August 14, 2000, and 60/236,721, filed October 2, 2000, under 35 USC §119(e), the disclosures of which are incorporated herein by reference. In addition, the present application is a continuation in part (CIP) of PCT application PCT/US00/20395, filed July 27, 2000, the disclosure of which is incorporated herein by reference.

## FIELD OF THE INVENTION

The present invention relates to sound enhancement systems.

## BACKGROUND OF THE INVENTION

Telephone sets are often used in noisy areas, in which background noise may interfere with understanding the voice signals received over the telephone set.
U.S. patent 4,829,565 to Goldberg, the disclosure of which is incorporated herein by reference, describes a telephone including an automated volume control system, which adjusts the volume of the remote signal sounded to the user responsive to the background noise. This system, however, may cause too many changes in the volume, as well as inaccurate changes, which may be annoying to the human ear.
U.S. patent 5,615,270 to Miller et al., the disclosure of which is incorporated herein by reference, describes a noise compensating system for a vehicle. The system determines the amplification required based on a noise signal generated by filtering a desired musical signal from a signal sensed in the vehicle.
U.S. patents 5,524,148 and 5,526,419 to Allen et al., the disclosures of which are incorporated herein by reference, describe noise compensation systems, which amplify a far end signal provided to a telephone set with a gain, determined responsive to a background noise level and an average speech power of the far end signal. In one embodiment, the background noise level and the average speech power are calculated for all the frequency bands of the far end signal and the same gain is applied to all the frequency bands of the far end signal. Due to the method used in determining the gain, the gain may not be sufficient or may be excessive.
In another embodiment of the Allen patents, the far end signal is divided into a plurality of frequency components and each frequency component is amplified by a respective gain. The gain of each frequency component is determined responsive to the background noise in that frequency component and the average speech power in that frequency component or the overall average speech power. In this embodiment, the sounded signal may be distorted, due to different, unrelated, amplifications of different frequency components of the signal. Furthermore, many amplitude adjustments may be performed unnecessarily, which may be wasteful in operation power consumption especially for battery powered systems.
PCT publication WO 99/01863, published January 14, 1999, the disclosure of which is incorporated herein by reference, describes a speech enhancement system for noisy environments. The system of WO 99/01863 compares the spectral analyses of the speech and background noise to determine whether one or more of the frequencies of the speech is masked by the background noise. If such masking occurs, one or more line spectral pairs (LSPs) of the speech are altered in order to eliminate the masking of the speech for that LSP. Altering the LSP may include shifting its frequency, increasing its bandwidth or increasing its amplitude. The shifting of the LSPs may distort the speech signal.
U.S. patent 5,636,272 to Rasmusson, the disclosure of which is incorporated herein by reference, describes a system for making speech more intangible, using a correction method that is not a function of the background noise.

## SUMMARY OF THE INVENTION

An aspect of some embodiments of the present invention relates to a noise compensation system for adjusting a desired audio signal so as to overcome a background noise. The system determines whether to amplify and/or an amplification gain of the audio signal based on an analysis of the audio and noise signals in frequency components of the signals. The determined amplification gain, however, is applied to the entire audio signal or to a portion of the audio signal including a plurality of frequency components. The determination of the amplification gain based on frequency components provides more accurate determination of the required gain, while the application of the gain to the entire audio signal prevents introduction of distortions to the signal.
In some embodiments of the invention, the determination of the gain includes comparing the power of the audio signal to the power of the noise signal in one or more frequency components and determining the gain responsive to the comparison. In some embodiments of the invention, the audio and noise signals are divided into a plurality of frequency components, which optionally cover substantially the entire speech spectrum of the signals, and the comparison is performed in substantially all the frequency components. Alternatively or additionally, the comparison is performed in fewer than all the frequency components, for example only in frequency components which include formants, i.e., envelope peaks in the spectrum, of the voice signal. In some embodiments of the invention, the comparison is performed in fewer than all the frequency components which include formants of the voice signal. In an exemplary embodiment of the invention, up to a predetermined number of different formants, e.g., three formants, are searched for in the voice signal. The comparison is performed for the frequency components which include formants found in the search.

In some embodiments of the invention, the amplification gain is chosen based on the signal to noise ratio (SNR) in the frequency component involved in the comparison, which has the lowest SNR. Optionally, the gain is applied to the entire audio signal. Alternatively, the gain is applied to substantially all the spectrum of the audio signal which is known to include speech signals. In some embodiments of the invention, after the signal is amplified by the amplification gain, the signal is compressed to avoid distortion in case the amplified signal exceeds its allowed dynamic range.

An aspect of some embodiments of the present invention relates to a noise compensation system, which amplifies one or more first frequency components of a voice signal, responsive to a determination that the voice signal requires amplification in one or more second frequency components, different from the first frequency components. The system divides the voice signal into a plurality of frequency components and for at least one of the frequency components determines whether the amplitude of the frequency component is sufficient. Responsive to a determination that the amplitude of a first frequency component is insufficient, the amplitude of at least one second frequency component is adjusted. In some embodiments of the invention, responsive to the determination, the amplitude of most or all of the frequency components are adjusted, possibly by the same adjustment factor.

An aspect of some embodiments of the present invention relates to a noise compensation system for adjusting a desired audio signal so as to overcome a background noise. The audio signal is partitioned into a plurality of frequency components and each frequency component is enhanced by a noise dependent gain and by a noise independent gain. Applying both a noise dependent gain and a noise independent gain to frequency components generated by the same partition, provides the advantages of both the gains without double costs and delay required for partitioning the signal. In some embodiments of the invention, at least part of the noise independent gain comprises a gain which is also independent of the signal, e.g., a predetermined fixed gain. In some embodiments of the invention, the noise dependent gain is the same for substantially all the frequency components.

In some embodiments of the invention, the noise dependent gain and the noise independent gain are applied to the audio signal by a single amplification unit. Alternatively, a plurality of amplification units, which apply respective portions of the gain to the audio signal, are used. Optionally, a first amplification unit applies only noise independent gains, and a second amplification unit applies both noise dependent and noise independent gains. Alternatively or additionally, a first amplification unit provides only a signal independent gain and a second amplification unit provides only a signal dependent gain.

It is noted that the term gain used herein may include also attenuations, i.e., gain factors smaller than one.

An aspect of some embodiments of the present invention relates to a noise compensation system for adjusting a desired audio signal so as to overcome a background noise. The noise compensation system calculates a corrected audio signal based on the background noise. An output of the system is equal to a weighted sum of the original audio signal and the compensated signal. By sounding the weighted sum instead of only the compensated signal, a compromise between the original signal (having the benefit of being original) and the enhanced signal (having the benefit of being enhanced) is provided.

In some embodiments of the invention, the weighted sum gives predetermined weights to the original audio signal and to the compensated signal. Optionally, even weight is given to the original audio signal and to the compensated signal. Alternatively or additionally, the weights of the weighted sum are adjusted responsive to the extent of the gain applied to the corrected audio signal and/or responsive to the extent of the background noise.

An aspect of some embodiments of the present invention relates to a method of identifying formants of an audio signal. The method includes determining power values for a plurality of frequency components of the audio signal, low pass filtering the power values of the frequency components, so as to average the power of each frequency component with its neighboring (in frequency) frequency components, and finding peaks in the power of the filtered power values.

Optionally, the frequency components are generated using a plurality of filters. Alternatively, the plurality of frequency components are generated using a Fourier transform. In some embodiments of the invention, the plurality of frequency components comprises between 10-24 frequency components, optionally between 12-15. Alternatively, the number of the plurality of frequency components comprises the number of FFT bins in the FFT used. In an exemplary embodiment of the invention, the values of the plurality of frequency components are calculated by performing an FFT and combining the values of a plurality of adjacent bins into a single frequency component value.

An aspect of some embodiments of the present invention relates to a noise compensation system for a two-way communication handset, e.g., a telephone, which performs noise compensation received from a far end, responsive to a determination that user at the near end is not talking. Thus, the power consumption of the noise compensation system is reduced. Generally, when the near end user is talking the far end user is silent, the near end user is not listening to the signals received from the far end or the noise compensation is not effective.

An aspect of some embodiments of the present invention relates to a method of determining a gain for enhancing a desired audio signal so as to overcome a background noise. The method includes determining at least two high-point values of the amplitude of the audio signal over different periods of time. The high point values are averaged and compared to a noise indication. Optionally, the gain is determined responsive to the comparison. In some embodiments of the invention, the noise indication is calculated from the background noise signal in a manner similar to the calculation of the average of the high point values of the audio signal.

In some embodiments of the invention, the averaging of the high point values comprises calculating a geometric or arithmetic average. Alternatively or additionally, any other averaging method may be used.

Optionally, the high-point values include maximums over the respective periods. Alternatively or additionally, one or more of the high point values comprise decaying maximums. That is, a maximum is stored and the stored value decays with time according to a predetermined function. The decaying maximum is compared to new values and is replaced if a new value is greater than the current value of the decaying maximum. Alternatively or additionally, the high point values comprise maximal values of a weighted version of the audio signal, in which more recent values are given higher weight.

An aspect of some embodiments of the present invention relates to a method of performing echo cancellation. The method includes finding a correlation between a signal generating the echo and the signal undergoing echo cancellation and removing only a single copy of signal generating the echo. This method is very simple relative to methods known in the art, although it provides lower performance. This method is especially advantageous when the echoes are direct echoes due to acoustic conditions.

There is therefore provided in accordance with an embodiment of the present invention, a method of processing an audio signal in order to overcome background noise extraneous to the audio signal, including comparing a measure of the audio signal in a frequency component of the audio signal to a measure of the noise in a frequency component of the background noise, determining a gain responsive to the comparison, and amplifying at least a portion of the audio signal, including at least one frequency segment not included in the frequency component of the audio signal, by the determined gain.

Optionally, the measure of the audio signal comprises a power of the audio signal. Optionally, the measure of the noise in the frequency component of the background noise comprises a power of a masking version of the noise. Possibly, amplifying the at least a portion of the signal comprises amplifying a portion including the compared frequency component of the audio signal.

Optionally, amplifying the at least a portion of the signal comprises amplifying the entire audio signal by the determined gain. In some embodiments of the invention, determining the gain to be applied comprises determining a gain which would bring the signal to noise ratio in the frequency band of the frequency component of the audio signal to above a threshold value.

Optionally, the threshold value is dynamically adjusted as the signal and/or noise measure changes in time. Alternatively, the threshold value is a predetermined value. Optionally, comparing a measure of the audio signal in a frequency component of the audio signal comprises comparing in a frequency component which includes a formant of the audio signal. Optionally, comparing in a frequency component which includes a formant of the audio signal comprises comparing in a frequency component of a frequency band with a lowest signal to noise ratio (SNR) among a plurality of frequency components of the audio signal.

Optionally, the method includes dividing the audio signal into a plurality of frequency components and selecting fewer than all the frequency components. Possibly, selecting fewer than all the frequency components comprises selecting frequency components including formants of the audio signal. Optionally, selecting frequency components including formants of the audio signal comprises selecting up to a predetermined number of frequency components including formants.

Optionally, the method includes choosing the frequency component of the audio signal, from the selected frequency components. Possibly, amplifying the at least a portion of the audio signal comprises amplifying by a gain combined from a plurality of gains including the gain determined responsive to the comparison. Optionally, the method includes sounding the amplified signal in the presence of the background noise.

Possibly, the frequency component of the audio signal and the frequency component of the noise span over substantially the same frequency band. Optionally, the frequency component of the audio signal comprises a band of frequencies.

There is further provided in accordance with an embodiment of the present invention, a method of processing an audio signal in order to overcome background noise extraneous to the audio signal, including dividing the audio signal into a plurality of frequency components, enhancing each of the frequency components by a respective noise independent gain of the frequency component, and multiplying each of the frequency components by a respective noise dependent gain of the frequency component.

Possibly, the method includes recombining the plurality of frequency components into an enhanced audio signal.

Optionally, dividing the audio signal into a plurality of frequency components comprises dividing into between 10-24 frequency components or more than 100 frequency components. Optionally, dividing the audio signal into a plurality of frequency components comprises dividing into a plurality of frequency components, which are substantially non-overlapping. Possibly, enhancing each of the frequency components by a respective noise independent gain comprises enhancing by predetermined signal-independent gains.

Possibly, multiplying each of the frequency components by a respective noise dependent gain comprises multiplying substantially all the frequency components by the same noise dependent gain. Possibly, the enhancing and multiplying are performed by a single functional element. Optionally, the enhancing and multiplying are performed by separate functional elements.

Optionally, the noise independent gain comprises a voiced speech enhancement factor if the audio signal includes voiced speech. Possibly, dividing the audio signal into a plurality of frequency components comprises applying a Fourier transform to the audio signal. Alternatively or additionally, dividing the audio signal into a plurality of frequency components comprises passing the audio signal through an array of band-pass filters.

There is further provided in accordance with an embodiment of the present invention, a method of processing an audio signal in order to overcome background noise extraneous to the audio signal, including receiving an audio signal, enhancing the audio signal responsive to a measure of the background noise, and providing an output that is a weighted sum of the enhanced audio signal and the received audio signal.

Optionally, enhancing the audio signal comprises multiplying a plurality of frequency components of the audio signal by respective gains. Optionally, providing the weighted sum comprises providing a weighted sum generated by dynamically adjusted weights. Optionally, the dynamically adjusted weights are determined responsive to the extent to which the audio signal was enhanced. In some embodiments of the invention, enhancing the audio signal comprises calculating a plurality of different gain factors and multiplying the audio signal by the plurality of gain factors, and wherein the dynamically adjusted weights are determined responsive to one of the gain factors.

Optionally, at least one of the different gain factors comprises a history dependent gain factor. Optionally, providing the weighted sum comprises providing a weighted sum generated by predetermined weights. Optionally, providing the weighted sum comprises providing a weighted sum in which the received audio signal is dominant, responsive to a determination that a listener to the provided weighted sum is talking. Optionally, providing the weighted sum comprises providing a weighted sum in which the received audio signal is dominant, responsive to a determination that the audio signal does not include speech signals.

There is further provided in accordance with an embodiment of the present invention, a noise compensation system, including an input interface adapted to receive an audio signal, a speaker adapted to sound an enhanced audio signal, a microphone adapted to collect background noise, that may interfere with a listener listening to the enhanced signal, and a controller adapted to compare a measure of the audio signal in a frequency component of the audio signal to a measure of the background noise in the same frequency component, determine a gain responsive to the comparison and amplify at least a portion of the audio signal, including at least one segment not in the frequency component, by the determined gain, so as to provide the enhanced audio signal.

Optionally, the speaker and microphone are part of a telephone hand-set. Optionally the system includes an echo canceller which removes at least one echo of the enhanced audio signal from the background noise. Optionally, the echo canceller removes only a single echo of the enhanced audio signal from the background noise.

There is therefore provided in accordance with an embodiment of the present invention, a method of determining a gain for enhancing an audio signal so as to overcome a background noise extraneous to the audio signal, including determining a plurality of high-point values over time of a measure of the audio signal, averaging the high point values, comparing the average to a measure of the noise, and determining a gain to enhance the audio signal responsive to the comparison.

Optionally, determining the plurality of high-point values comprises determining high point values for different time segments of the audio signal. Optionally, determining the plurality of high-point values comprises determining high point values for time segments of the audio signal having different lengths. Optionally, determining the plurality of high-point values comprises determining maximal values. Alternatively or additionally, determining the plurality of high-point values comprises determining maximal values of a weighted version of the audio signal, in which more recent values are given higher weight. Optionally, averaging the high-point values comprises calculating a geometric average.

## BRIEF DESCRIPTION OF FIGURES

Exemplary non-limiting embodiments of the invention will be described with reference to the following description of embodiments in conjunction with the figures. Identical structures, elements or parts which appear in more than one figure are preferably labeled with a same or similar number in all the figures in which they appear, in which:

Fig. 1 is a schematic illustration of a noise compensation system, in accordance with an embodiment of the present invention;

Fig. 2A is a schematic block diagram of a controller of a noise compensation system, in accordance with an embodiment of the present invention;

Fig. 2B is a schematic block diagram of a controller of a noise compensation system, in accordance with another embodiment of the present invention;

Fig. 3 is a schematic illustration of a logic unit of the controller of Fig. 2A or Fig. 2B, in accordance with an embodiment of the present invention;

Fig. 4 is a schematic illustration of a gain determination unit of the logic unit of Fig. 3, in accordance with an embodiment of the present invention;

Figs. 5A and 5B show graphs of an exemplary voice signal before and after correction by a gain generated by a formants unit, in accordance with an embodiment of the present invention;

Fig. 6 is a schematic graph of a gain of an enhance filter, in accordance with an embodiment of the present invention;

Fig. 7 is a schematic graph of an exemplary noise power spectrum and a masked version thereof, in accordance with an embodiment of the present invention; and

Fig. 8 is a schematic block diagram of a speech detector, in accordance with an embodiment of the present invention.

## DETAILED DESCRIPTION OF EMBODIMENTS

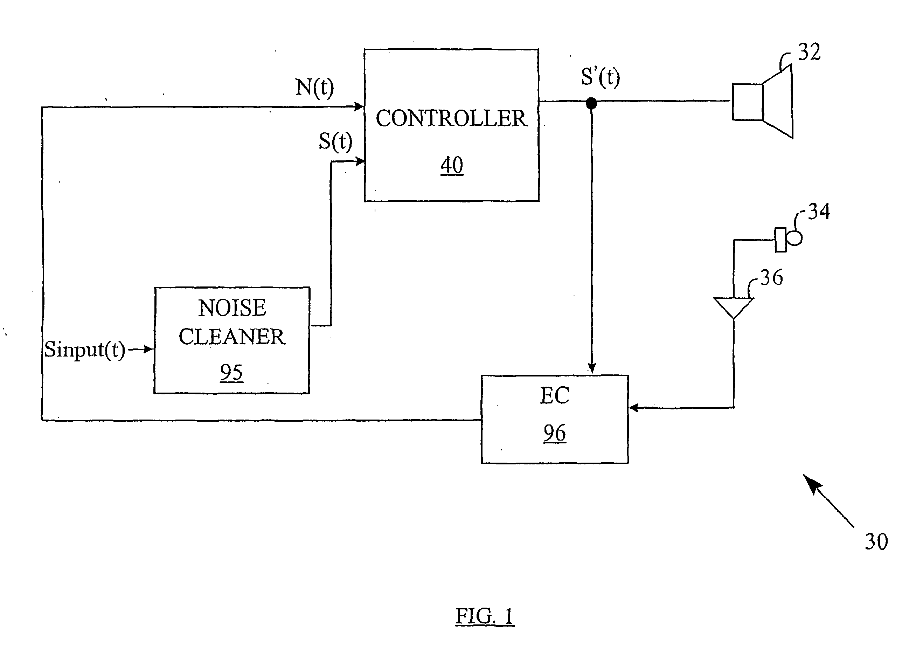

Fig. 1 is a schematic illustration of a noise compensation system 30, in accordance with an embodiment of the present invention. System 30 receives an input voice signal Sinput(t) which is to be sounded by a speaker 32. For example, Sinput(t) is received from a remote party in a telephone conversation. A controller 40 receives input voice signal Sinput(t) and an estimate N(t) of the noise in the vicinity of speaker 32, and provides a noise compensated input signal S'(t), which is a noise compensated version of input voice signal Sinput(t).

In some embodiments of the invention, input voice signal Sinput(t) is passed through a noise cleaner 95, which provides a noise filtered version S(t) of input voice signal Sinput(t). Noise cleaner 95 operates without relation to the noise level in the vicinity of speaker 32. Noise cleaner 95 optionally measures the noise when there is no speech signal and determines the spectral form of the noise. Noise cleaner 95 then optionally removes the spectral representation of the noise from the spectral representation of signal portions including speech. Alternatively or additionally, any other noise cleaner known in the art may be used, such as described in U.S. patent 5,550,924 to Helf et al. and/or in "Utilizing Interband Acoustical Information For Modeling Stationary Time-Frequency Regions of Noisy Speech" by Yoo, Acoustics, Speech, and Signal processing, 1999, IEEE proceedings pages 809-812, vol. 2, the disclosures of which are incorporated herein by reference. Alternatively or additionally, a noise cleaner is situated with controller 40, after the frequency components are determined. Thus, the extracting of the spectrum performed by controller 40 may be used also for the noise cleaner.

In some embodiments of the invention, noise estimate N(t) is generated responsive to an input noise signal n(t), collected by a microphone 34 in the vicinity of speaker 32. Optionally, input noise signal n(t) is amplified by an amplifier 36 and passed through an echo canceller (EC) 96 so as to provide noise estimate N(t). Echo canceller 96 removes from input noise signal n(t) echoes of outputted signal S'(t), collected by microphone 34 and/or which pass into n(t) due to acoustic coupling.

In some embodiments of the invention, echo canceller 96 finds, for a recent predetermined-size segment (e. g., a few msec) of outputted signal S'(t), a maximal correlation segment in the noise signal n(t). Echo canceller 96 optionally determines a correlation value of the segments and the time difference between them. In some embodiments of the invention, echo canceller 96 delays voice signal S'(t) by the time difference between the segments and multiplies the delayed voice signal by the determined auto-correlation value. The noise estimate N(t) is optionally calculated as the sensed noise signal n(t) from which the multiplied and delayed voice signal is subtracted. Thus, echo canceller 96 is simpler than other echo cancellers known in the art, although at the cost of being less accurate. Alternatively or additionally, any other echo canceller may be used, including, for example, echo cancellers which utilize adaptive filtering.

Further alternatively or additionally, the noise n(t) is not passed through an echo canceller. In an exemplary embodiment of the present invention, an echo canceller is not used when microphone 34 is not close to speaker 32, for example when microphone 34 is positioned close to a source of noise, rather than close to speaker 32. For example, when the major source of noise is known, e.g., a motor of a car, microphone 34 may be positioned near the motor. In an exemplary embodiment of the invention, speaker 32 and microphone 34 are positioned in a telephone with at least about 90° relative to each other, for example vertically or opposite facing. In these exemplary embodiments, system 30 optionally does not include an echo canceller.

In some embodiments of the invention, noise compensation system 30 compensates for noises in the vicinity of a wired or cellular telephone set. Optionally, system 30 is positioned within the telephone set. Alternatively or additionally, system 30 or portions thereof are positioned within a telephone network servicing telephone sets. Microphone 34 is optionally a regular telephone-set-microphone which is used for collecting input noise signal n(t), in addition to its ordinary use. Alternatively or additionally, microphone 34 is a free-hands microphone attached to a telephone set Further alternatively or additionally, microphone 34 is independent of the regular microphone of the telephone set.

In other embodiments of the invention, system 30 is used with other voice sounding and/or audio systems, such as announcement systems, music systems, video-conferencing systems, radios and/or televisions. In some embodiments of the invention, a plurality of microphones are used to collect noise signals which are used in estimating noise N(t). The one or more microphones 34 may be positioned close to the source of noise, close to a listener and/ or in any other positioned suitable for determining the noise level which is to be compensated for. In some embodiments of the invention, a single input signal Sinput(t) is sounded by a plurality of speakers 32. Accordingly, system 30 corrects the input signal differently for each speaker 32 responsive to a respective noise estimate N(t).

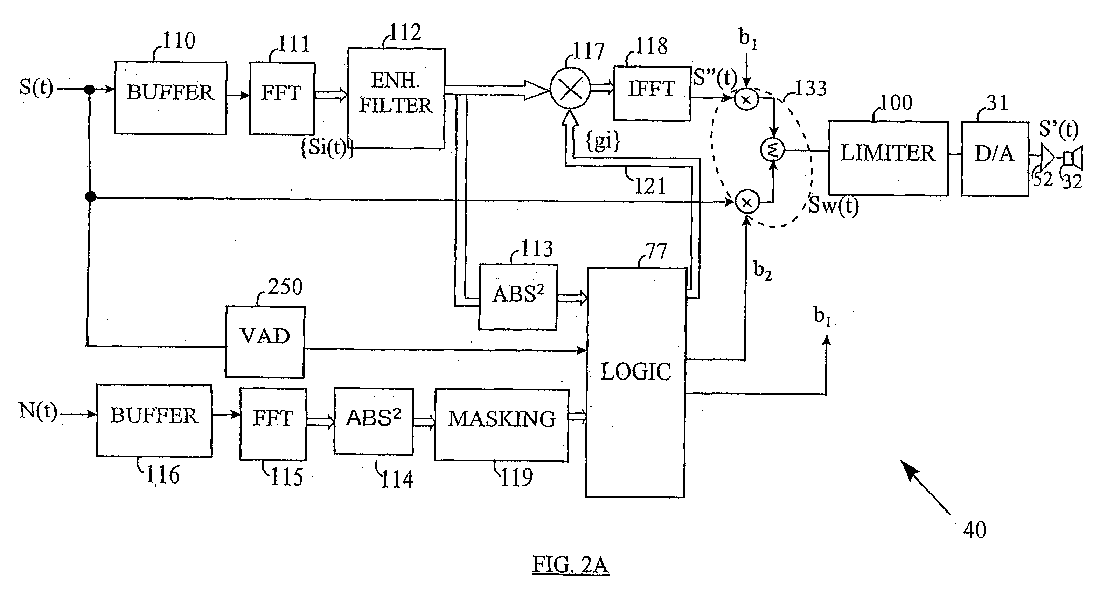

Fig. 2A is a schematic block diagram of controller 40, in accordance with an embodiment of the present invention. Controller 40 optionally receives input signal S(t) and noise estimate signal N(t) as a stream of digital samples provided at a predetermined rate, e.g., a sample every 10 or 12.5 msec. Alternatively or additionally, input signal S(t) and/or noise signal N(t) are provided as analog signals which are converted to digital streams using suitable analog to digital converters (not shown). In some embodiments of the invention, a predetermined number of samples of voice signal S(t) and noise signal N(t) are accumulated in buffers 110 and 116, respectively. The accumulated samples are optionally passed through fast Fourier transform (FFT) units 111 and 115, respectively, so as to provide values $S_1$, $S_2$, ..., $S_n$ for a plurality of frequency components of input signal S(t) and a plurality of respective frequency component values $N_1$, $N_2$, ..., $N_m$ of noise signal N(t). Alternatively or additionally, other Fourier transform methods are used and not necessarily the FFT.

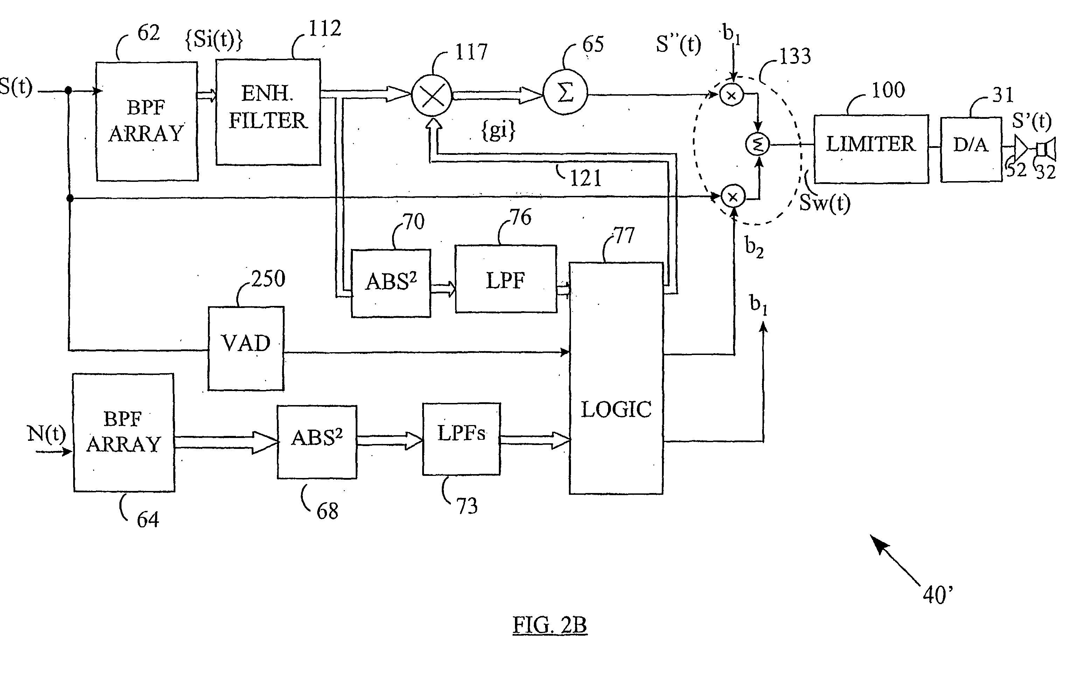

In some embodiments of the invention, each bin of the FFT corresponds to a respective frequency component. Alternatively, each frequency component comprises a group of respective bins. In some embodiments of the invention, substantially all the frequency components, except for example the extremes, are formed of the same number of bins. Alternatively or additionally, the bands of the frequency components are predetermined, for example as described hereinbelow with reference to Fig. 2B, and the values of the bins included in each frequency band are used in determining the value of the frequency component.

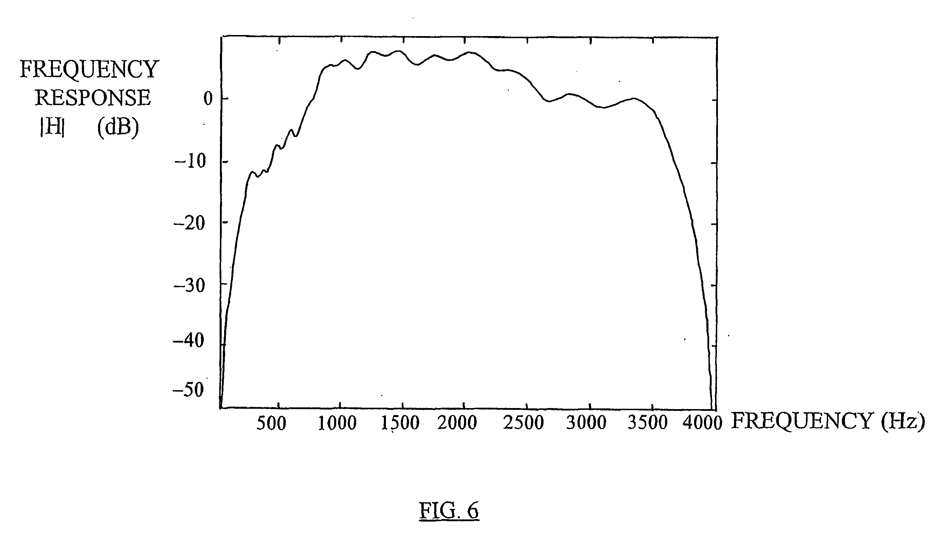

Frequency component values $S_1$, $S_2$, ..., $S_n$ are optionally filtered by an enhance filter 112 which emphasizes specific frequency components according to a predetermined emphasis scheme, so as to increase the intelligibility of voice signal S(t). Enhance filter 112 optionally enhances the amplitude of frequency components which include major speech frequencies, so as to emphasize speech signals. An exemplary embodiment of enhance filter 112 is described hereinbelow with reference to Fig. 6. Thereafter, the enhanced frequency component values are multiplied, in a multiplication unit 117, by respective gain factors ($g_i$, on lines 121) determined by a logic unit 77, responsive to the noise N(t) and voice signals S(t), as described hereinbelow. Thus, each frequency component is multiplied by a noise independent value, by enhance filter 112, and by a noise dependent value, by multiplication unit 117.

By emphasizing the speech signals by enhance filter 112 before performing the noise dependent correction, the noise dependent correction is concentrated at handling the speech components of voice signals S(t). It is noted that, as described below, the noise dependent correction is generally the same for all the frequency components, so as not to cause distortions in the voice signal. The noise independent correction, on the other hand, may have different gains for different frequency components. Although applying different gains to different frequency components may distort the voice signal, such distortions have known affects and do not depend on values external to the adjusted signal, e.g., the noise. In some embodiments of the invention, as described hereinbelow, the gain {$g_i$} of multiplication unit 117 is a combination of noise dependent and noise independent corrections.

Alternatively or additionally to positioning enhance filter 112 before multiplication unit 117, enhance filter 112 (or a second enhance filter) could operate on the output of multiplication unit 117. Performing both the noise dependent and the noise independent corrections based on a single extraction of frequency components, may reduce the complexity of noise compensation system 30.

The multiplied frequency component values are optionally converted back to the time domain by an inverse FFT (IFFT) unit 118, so as to provide an adjusted voice signal S''(t). In some embodiments of the invention, a weighted average unit 133 generates a weighted sum $S^W(t)$ of adjusted voice signal S''(t) and the input voice signal S(t) based on respective weights $b_1$ and $b_2$, ($b_1+b_2=1$), generated by logic unit 77, as described hereinbelow. The weighted sum is optionally provided to a soft limiter 100 which adjusts the weighted sum, if necessary, so that the weighted sum does not exceed the operation range of speaker 32. The signal from limiter 100 is optionally converted to an analog signal by a digital to analog (D/A) converter 31, amplified by a power amplifier 52 and sounded by speaker 32. Alternatively, D/A converter 31 is positioned before the adder of weighted average unit 133 or before limiter 100.

In some embodiments of the invention, limiter 100 restricts the weighted sum $S^W(t)$ to a range between predetermined operation limits of amplifier 52. Alternatively or additionally, the range to which weighted sum $S^W(t)$ is limited by limiter 100, is determined periodically based on a current dynamic range of amplifier 52. Optionally, limiter 100 is restricted between symmetric limits, i.e., -limit < $S^W(t)$ < +limit. In an exemplary embodiment of the invention, limiter 100 carries out the following function:

$$F(x) = limit * 2 * [A * e^{-2x} * arctan(x)+(1-A) * e^{-4x} * arctan(x)]/\pi$$

in which A is an arbitrary value between 0 and 1, x is the signal to be limited and F(x) is the limited signal.

Alternatively or additionally to using limiter 100, the dynamic range of power amplifier 52 is greater than the dynamic range of the signals entering controller 40, such that the controller 40 substantially cannot generate signals beyond the dynamic range of power amplifier 52. Further alternatively or additionally, as described hereinbelow, the gain generated by logic unit 77 includes compression factors which substantially eliminate the need for limiter 100. It is noted, however, that in some embodiments of the invention, limiter 100 is used even when the gain generated by logic unit 77 includes compression factors, so as to prevent any distortions.

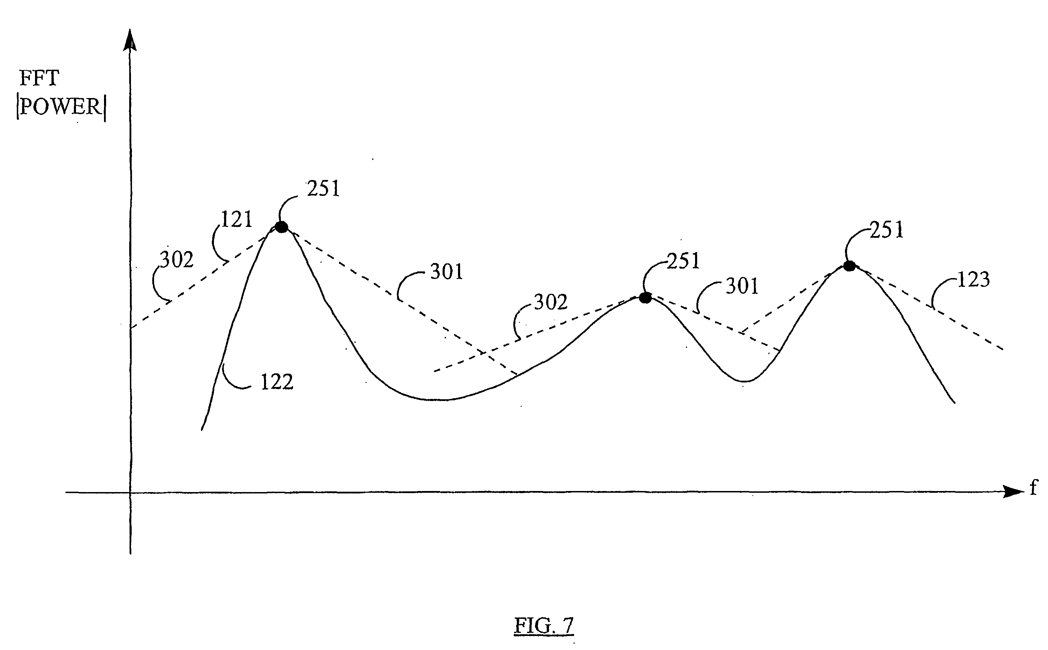

In some embodiments of the invention, logic unit 77 receives for each frequency component of voice signal S(t) a power level $ES_i$ and for each frequency component of noise signal N(t) a power level $EN_i$. Optionally, a power determination unit 113, which generates the square of the absolute value of the signal ($ABS^2$), receives the enhanced values of the frequency components of S(t) from enhance filter 112 and determines therefrom the power $ES_i$ of each of the frequency components. In some embodiments of the invention, the frequency components of noise signal N(t), generated by FFT unit 115, are passed through a power determination unit 114 ($ABS^2$), which calculates the power $EN_i$ of noise signal N(t) in each of its frequency components. Optionally, the noise power signals $EN_i$ are passed through a masking unit 119 which adjusts the noise power signals $EN_i$ according to human acoustic considerations, as described hereinbelow, with reference to Fig. 7.

In some embodiments of the invention, voice signal S(t) and noise signal N(t) are divided into the same number of frequency components (i.e., n=m) with the same frequency component division. Alternatively, voice signal S(t) and noise signal n(t) are divided into different numbers of frequency components. In some embodiments of the invention, noise signal N(t) is converted into a spectrum including a larger bandwidth. Optionally, in these embodiments, noise signal N(t) is divided into more frequency components than voice signal s(t), optionally 1 or 2 more frequency components. In some embodiments of the invention, the additional frequency components of noise signal N(t) are used by masking unit 119, so as to take into account noise frequencies of high bands which influence lower bands. Optionally, the noise and voice signals provided to logic unit 77 include the same number of frequency components.

In some embodiments of the invention, both voice signal S(t) and noise signal n(t) are sampled at a common sufficiently high sampling rate, which allows generation of the higher number of frequency components of the noise signal. Alternatively, noise signal n(t) is sampled at a higher frequency than voice signal S(t), so that a larger number of frequency components may be generated from the sampled signal n(t). Optionally, noise signal n(t) is then down sampled to the sampling rate of voice signal S(t) so as to allow easy comparison of the signals. Alternatively, voice signal S(t) is padded by adding zero values to the high frequencies.

In some embodiments of the invention, a voice activity detection (VAD) unit 250 determines when S(t) does not include speech signals (e.g., during silence periods between words) and substantially disables logic unit 77 when S(t) does not include speech signals. Thus, noise included in voice signal S(t) between words is not amplified to "overcome" background noise n(t). Optionally, when VAD unit 250 determines that the input does not include speech signals, logic unit 77 provides output gains $\{g_i\}$ from a previous time at which voice signal S(t) did include speech. Alternatively or additionally, one or more elements of logic unit 77 do not provide an output in order to reduce power consumption. Optionally, when voice signal S(t) is determined not to include speech, the voice signal S(t) is provided to speaker 32 substantially without changes. Alternatively, the voice signal S(t) is cut out and no signal is sounded when the voice signal does not include speech signals.

In some embodiments of the invention, VAD unit 250 determines whether the voice signal S(t) includes speech signals based on a comparison of the amplitude of the signal to a voice threshold. Optionally, the voice threshold is set responsive to a level of a session start up noise level, e.g., measured at the beginning of a telephone conversation. Alternatively, the voice threshold is factory calibrated or is otherwise predetermined. Further alternatively, the voice threshold is adaptively adjusted responsive to continuously and/or periodically acquired noise measurements. In some embodiments of the invention, the threshold is set to a predetermined multiple of the measured noise, e.g., between 3-5 times the noise. Alternatively or additionally, any other VAD operation method, known in the art, may be used.

In some embodiments of the invention, processing iterations of controller 40 are applied to a predetermined number of samples, e.g., between 100-1000 samples, optionally depending on the sampling rate. Optionally, the processing iterations of controller 40 are applied to a number of samples which is a power of 2, e.g., 128, 256 or 512 in order to allow performing the Fourier transform using a fast Fourier transform (FFT) method. In some embodiments of the invention, the number of samples used in each iteration is adjusted as a compromise between a required accuracy, which may require a large number of samples, and shortening the delay, which mandates a small number of samples. Optionally, a user may adjust the number of samples used in the processing iterations at a specific time. In some embodiments of the invention, the delay is set according to the total delay of the signals from their origin to speaker 32. For example, when system 30 is used in a telephone, if the round trip delay (RTD) of signals is relatively low, an FFT with a large number of samples, incurring a relatively large delay, e.g., 20 ms, may be used. If, however, the RTD of signals is relatively high, the delay of system 30 may be limited to 5 or 10 ms, by reducing the number of samples on which the FFT is performed.

Optionally, each processing iteration is performed on a non-overlapping group of samples. Alternatively, each processing iteration is performed on a group of samples which partially overlaps the samples used in one or more previous processing iterations. In an exemplary embodiment of the present invention, processing iterations are performed each time 128 samples are collected, on a group of 256 most recent samples. In some embodiments of the invention, the amount of overlapping samples is adjusted as a function of speech quality versus power consumption. When it is desired to minimize power consumption, fewer processing iterations are performed, with low or no overlap. When high speech quality is desired, frequent processing iterations, with a high overlap rate, are performed. Optionally, the user may select the processing iteration rate desired.

Alternatively to generating frequency component values using a Fourier transform, an array of band-pass filters are used to generate frequency component signals of the voice and noise signals, as is now described with reference to Fig. 2B. Using an array of filters, allows system 30 to operate substantially without incurring a delay.

Fig. 2B is a schematic block diagram of a controller 40', in accordance with an embodiment of the present invention. Controller 40' is similar to controller 40 and can be used in system 30 instead of controller 40. In the following description, only elements in which controller 40' is different from controller 40, are described. In controller 40', voice signal S(t) and noise signal N(t) are passed through respective band-pass filter (BPF) arrays 62 and 64, which generate a plurality of frequency component voice signals $S_1(t)$, $S_2(t)$, ..., $S_n(t)$ and frequency component noise signals $N_1(t)$, $N_2(t)$, ..., Nm(t).

The number of voice and noise frequency components may be in accordance with any of the alternatives described above with reference to controller 40. In some embodiments of the invention, the number of filters in filter array 62 is between about 10-60 depending on the quality required and the frequency range to be covered by controller 40. Optionally, the frequency range of controller 40 includes the audio frequency range, e.g., between 20 Hz and 20 KHz. Alternatively, the frequency range of controller 40 includes the human audio frequency range, e.g., up to between 4-7 kHz. Further alternatively or additionally, the frequency range includes a smaller or larger range of frequencies, for example if system 30 is used for pets.

In some embodiments of the present invention, the frequency components up to 1 kHz have a bandwidth of approximately 100 Hz, and frequency components at higher ranges have bandwidths logarithmically related to the frequencies. Optionally, the frequencies of the frequency components are selected according to acoustic and/or other characteristics of the human ear, e.g., frequencies which are percepted substantially different by the human ear are included in different frequency components.

In some exemplary embodiments of the invention, the division into frequency components is performed in accordance with the critical voice bands, known in the art. The number of frequency components used in these exemplary embodiments depends on the range of frequencies considered important. For the range between 0-20 kHz, these exemplary embodiments optionally use about 24 frequency components. For the range between 300-4000 Hz, these embodiments optionally use frequency components centered around the following frequencies: 450, 570, 630, 700, 840, 1000, 1170, 1370, 1600, 1850, 2150, 2500 and 2900 Hz. Optionally, one or two additional frequency components centered around 350 Hz and/or 3400 Hz are also used.

In another exemplary embodiment of the present invention, the frequency components include the following frequency ranges 400-510, 510-630, 630-770, 770-920, 920-1080, 1080-1270, 1270-1480, 1480-1720, 1720-2000, 2000-2320, 2320-2700 and 2700-3150 Hz. It is noted that the frequencies below 400 Hz and above 3150 Hz are covered by the first and last frequency components, although with a lower significance than the frequencies within the frequency ranges of the frequency components.

It is noted that the above examples are not limiting and any other set of frequency components may be used. Particularly, a larger number of frequency components, e.g., 32, 48 or even 65, may be used. Alternatively or additionally, the ranges of the frequency components may partially overlap or may cover less than the entire frequency range of the voice signals.

In some embodiments of the invention, the filters in arrays 62 and 64 comprise Butterworth filters, optionally having at least two, three, four, five or even six stages. In an exemplary embodiment of the invention, when a low power consumption of system 30 is required, two or three stages are used. When high accuracy is required, at least five or six stages are optionally used. In some embodiments of the invention, the number of stages is chosen so that the filters imitate the masking effect of noise over speech inside the human ear.

Optionally, the limits of the frequency components are the -3dB points of the filters. In some embodiments of the invention, the maximal amplification of the filters is about 1. Alternatively or additionally, some or all of the filters in array 62 and/or in array 64 are of other types, such as Chebyshev, Bessel or elliptic filters. Optionally, noise and voice filters of corresponding frequency components have the same characteristics. Alternatively or additionally, at least some of the noise and voice filters of corresponding frequency components have different characteristics. For example, in some embodiments of the invention, the filters of filter array 62 perform some or all the enhancement of enhance filter 112 (optionally enhance filter 112 is eliminated in these embodiments), In these embodiments, the filters of array 62, which perform enhancement may be different from the filters of array 64.

In some embodiments of the invention, controller 40' includes a multiplier array 70 which squares each of the voice frequency component signals $S_i(t)$ to derive power signals $ES_i(t)$. The power signals $ES_i(t)$ are optionally filtered by respective low pass filters (LPF) 76 and are then sampled by a sampler (not shown) to generate frequency component power values ESi. Alternatively to using a sampler, logic unit 77 performs the sampling when the values are read at its inputs. Low pass filters 76 optionally smooth power signals $ES_i(t)$ before the sampling, so that the sampling does not take a non-representative fluctuated value. Similarly, noise frequency component signals $N_i(t)$ are passed through respective multipliers in a multiplier array 68 which squares each of the signals. The squared signals are optionally filtered by an array of low pass filters (LPFs) 73 and sampled to generate frequency component power values $EN_i$.

In some embodiments of the invention, LPFs 73 and/or 76 comprise first or second order filters. Optionally, the low pass filters have a -3dB point which depends on the low frequency boundary $F_{min}$ of the respective frequency component. In an exemplary embodiment of the present invention, the -3dB point is approximately at $F_{min}/k$, wherein k is between about 1.5 and 2, so as to capture a DC component of the power signal. Alternatively or additionally, one or more of the low pass filters have a -3dB point which depends on the high frequency boundary of the respective frequency component. Further alternatively or additionally, any other suitable low pass filters are used. Further alternatively or additionally, any other suitable method and/or filter for dynamically extracting the DC component of the power signal (which is generally equal to the average power), is used.

After multiplication unit 117, the frequency component signals $S_1(t)$, $S_2(t)$, ..., $S_n(t)$ are optionally combined, for example, by a signal adder 65.

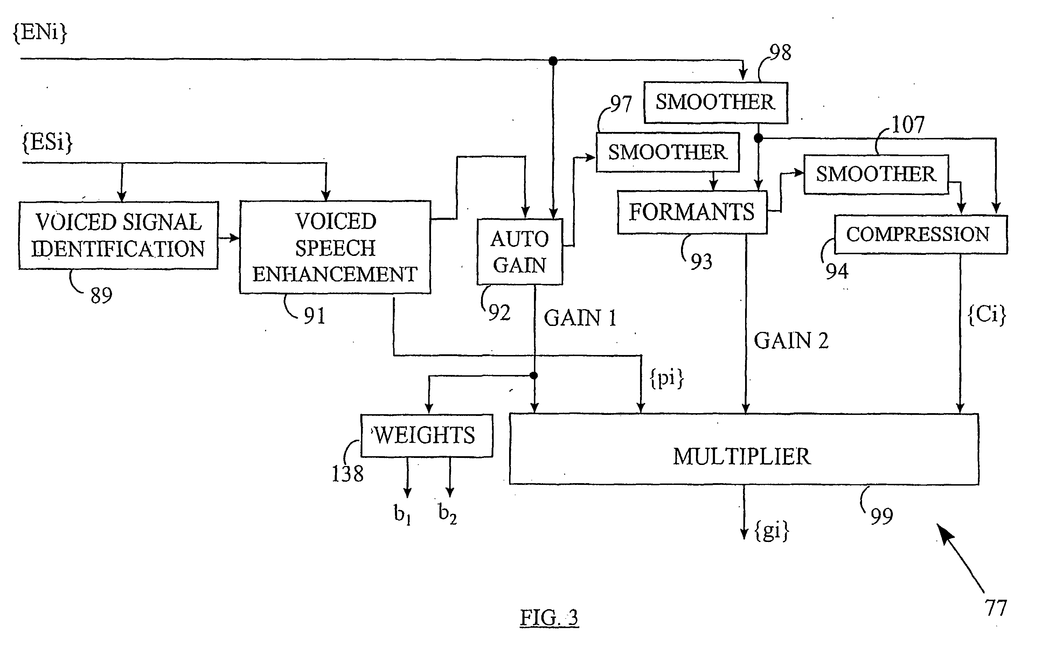

Fig. 3 is a schematic illustration of logic unit 77, in accordance with an embodiment of the present invention. Logic unit 77 comprises a plurality of gain determination units, which determine gain factors which are to multiply the frequency components of voice signal S(t) responsive to various evaluations of voice signal S(t), as represented by power vector $\{ES_i\}$. In the embodiment of Fig. 3, the plurality of gain determination units comprise a voiced speech enhancement unit 91, an auto gain unit 92, a formants unit 93 and a compressor unit 94. It is noted, however, that logic unit 77 may include fewer units and/or additional units, in accordance with various embodiments of the invention. A multiplier 99 optionally receives gain factors determined by the gain determination units and provides gain factors $\{g_i\}$, which are provided to multiplication unit 117 (Fig. 2A or Fig. 2B). Alternatively, each of units 91, 92 93 and 94 receives the gain of the previous unit and provides an accumulated calculated gain.

Logic unit 77 optionally comprises a voiced speech identification unit 89 which determines whether voice signal S(t), as represented by power vector $\{ES_i\}$, currently comprises voiced speech or unvoiced speech. As is known in the art, sounds that are created by the spectral shaping of the glottal pulses are referred to as voiced speech sounds, while sounds pronounced without the aid of the vocal cords are referred to as unvoiced speech sounds.

In some embodiments of the invention, identification unit 89 identifies the formants of voice signal S(t) and accordingly determines whether the voice signal includes voiced speech. Optionally, if voice signal S(t) includes a dominant pitch, e.g., having an amplitude substantially greater than all other pitches, the signal is considered as including voiced speech. Alternatively or additionally, identification unit 89 compares the energy in the low frequencies of voice signal S(t) to the energy in the high frequencies. Optionally, if the energy of the low frequencies is higher, by a predetermined threshold from the energy of the high frequencies, voice signal S(t) is considered voiced. In an exemplary embodiment of the present invention, the frequency band of voice signal S(t) is split substantially evenly between low and high frequencies. Alternatively, the division between low and high frequencies may be at any other point according to acoustic considerations.

In some embodiments of the invention, identification unit 89 determines that the signal includes voiced speech only when the signal has clear characteristics of voiced speech. This is because voiced speech enhancement unit 91 generates a gain that changes the signal only if the signal is determined to include voiced speech.

Alternatively or additionally, any other method for identifying voiced speech may be used, for example the method described in the above mentioned paper by Yoo and/or the methods described in U.S. patent 4,468,804 to Kates et al., the disclosure of which is incorporated herein by reference.

Voiced speech enhancement unit 91 optionally receives from identification unit 89 an indication on whether voice signal S(t) includes voiced speech. In some embodiments of the invention, if voice signal S(t) includes voiced speech, enhancement unit 91 selects a voiced speech emphasis vector $(p_1, p_2, ..., p_n)$ which is suitable for emphasizing the frequency components of voice signal S(t) which carry the voiced speech. Optionally, voiced speech emphasis vector $(p_1, p_2, ..., p_n)$ comprises a predetermined vector which is used for substantially all voiced speech signals. Alternatively, the speech emphasis vector $(p_1, p_2, ..., p_n)$ is a function of the power vector $\{ES_i\}$.

In some embodiments of the invention, the speech emphasis vector $(p_1, p_2, ..., p_n)$ enhances the power of low frequencies and/or lowers the power of high frequencies. For example, speech emphasis vector $(p_1, p_2, ..., p_n)$ may be a non-increasing monotonous function. In some embodiments of the invention, when identification unit 89 provides an unvoiced speech indication, speech emphasis vector $(p_1, p_2, ..., p_n)$ is equal to a unit vector which does not change the amplitude of voice signal S(t).

In some embodiments of the invention, enhancement unit 91 also provides a modified power vector $\{ESM_i\}$, which equals power vector $\{ES_i\}$ multiplied by emphasis vector $(p_1, p_2, ..., p_n)$. Optionally, modified power vector $\{ESM_i\}$ is used to represent the power of voice signal S(t) by the auto-gain unit 92.

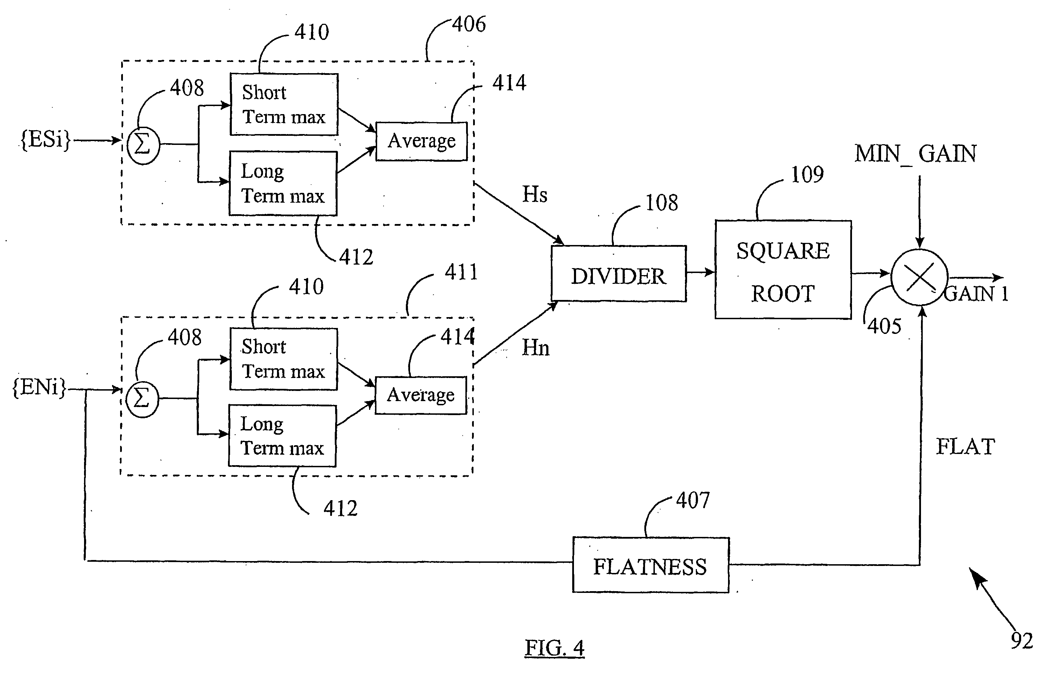

In some embodiments of the invention, auto-gain unit 92 determines a first gain factor (Gain1) for signal S(t) based on a comparison of a typical power of voice signal S(t) and a typical power of noise signal N(t). The typical powers are optionally determined based on a history of the signals over a recent period. The first gain factor is optionally designed to bring the voice signal S(t) to be generally above the noise signal N(t), while formants unit 93 performs a particular comparison for the voice and noise signal at the current time. In an exemplary embodiment of the invention, auto-gain unit 92 is as described hereinbelow with reference to Fig. 4. Optionally, auto-gain unit 92 also provides an amplified power vector $\{Gain1 \times ESM_i\}$, which is used by formants unit 93 to represent signal S(t).

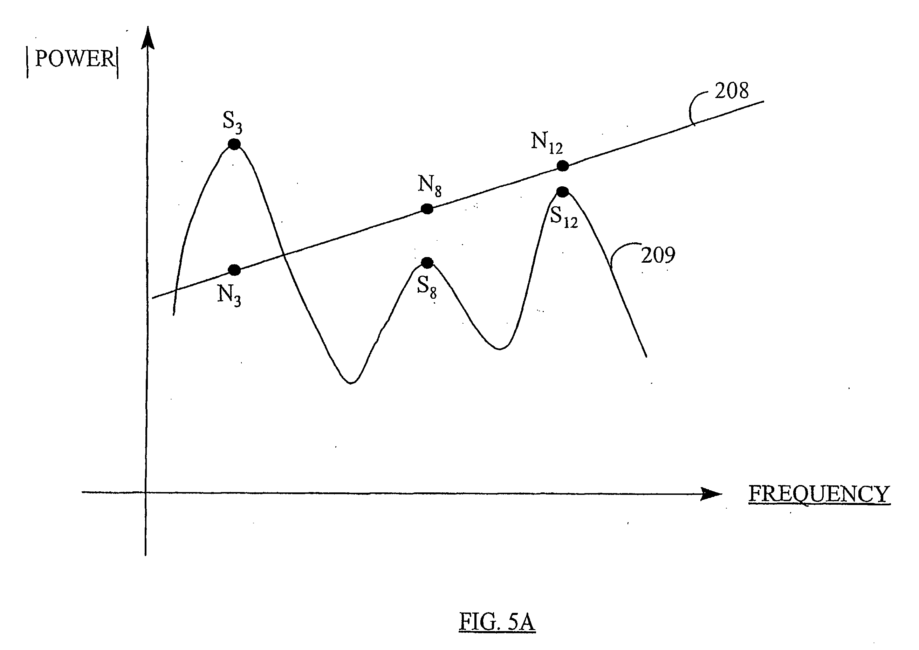

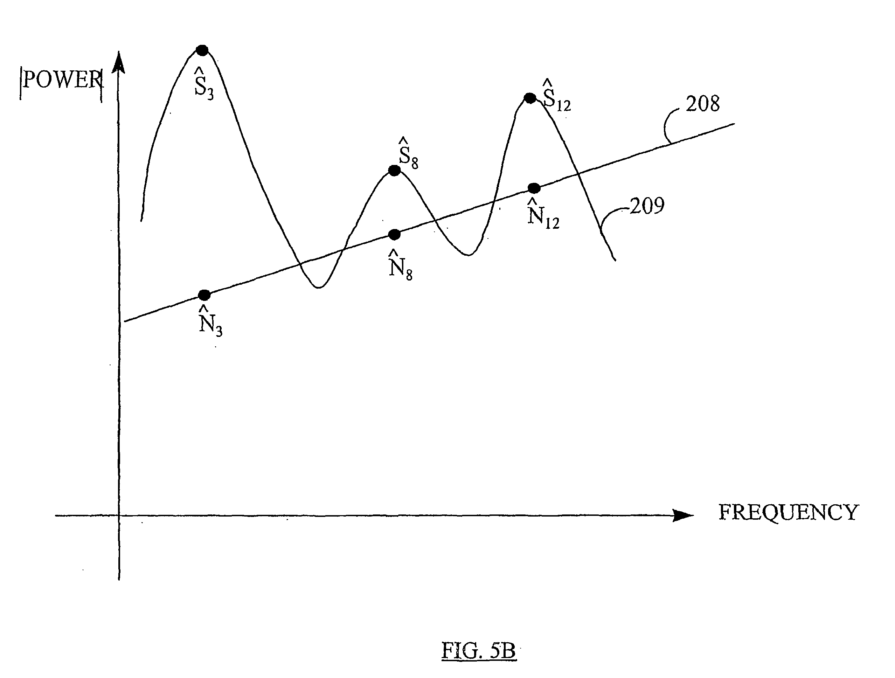

In some embodiments of the invention, formants unit 93 identifies one or more formants of voice signal S(t), and accordingly generates a second gain factor (Gain2). The second gain factor (Gain2) optionally is selected as a minimal gain required to ensure that the power of frequency components corresponding to a predetermined group of formants of voice signal S(t) have values above the power of the corresponding frequency components of noise signal N(t), by at least a predetermined margin. Optionally, the predetermined margin is the same for all the frequency components. Alternatively, different margins are used for different frequency components. In some embodiments of the invention, the predetermined margin is equal to between about 3-10 dB, optionally 6 dB. In an exemplary embodiment of the invention, formants unit 93 is as described hereinbelow with reference to Figs. 5A and 5B. Optionally, formants unit 93 also provides an amplified power vector $\{Gain2 \times Gain1 \times ESM_i\}$, which is used by compression unit 94 to represent signal S(t).

In some embodiments of the invention, the amplified power vector $\{Gain1 \times ESM_i\}$ from auto-gain unit 92 is passed through a pre-formant smoother 97, which smoothes the amplified power vector $\{Gain1 \times ESM_i\}$. The smoothing is optionally performed since the search for formants is performed on the envelope of the spectrum of voice signal S(t) and not on the voice signal itself, which may include many unimportant peaks.

Each frequency component value in the smoothed vector (denoted $\{ESM_i'\}$) is optionally equal to a weighted average with its neighboring frequency components. In an exemplary embodiment of the invention, pre-formant smoother 97 operates in accordance with the following equation:

$$ESM_i' = Gain1 \times (0.5 \times ESM_i + 0.25 \times ESM_{i+1} + 0.25 \times ESM_{i-1})\ 2 \leq i \leq n-1$$

$$ESM_1' = Gain1 \times (0.66 \times ESM_1 + 0.34 \times ESM_2)$$

$$ESM_n' = Gain1 \times (0.66 \times ESM_n + 0.34 \times ESM_{n-1})$$

Alternatively, any other smoothing function is used, for example functions which take into account a larger number of neighboring frequency components and/or which use other weighting factors.

In some embodiments of the invention, formants unit 93 receives a smoothed version of the noise power vector $\{EN_i\}$, referred to herein as $\{EN_i'\}$. Optionally, the smoothed noise power vector $\{EN_i'\}$ is generated by a noise smoother 98, which performs the same function as pre-formant smoother 97. Alternatively, noise smoother 98 performs a different function from pre-formant smoother 97, optionally generating a less smooth signal. Noise power vector $\{EN_i\}$ is optionally smoothed so that it matches the smoothed version of $\{Gain1 \times ESM_i\}$.

In some embodiments of the invention, compression unit 94 generates a compression vector $(c_1, c_2, ..., c_n)$ suitable for reducing the power of the adjusted voice signal S(t). Optionally, compression vector $(c_1, c_2, ..., c_n)$ is suitable for reducing the power of the adjusted voice signal S(t) into the operation limits of power amplifier 52 and/or speaker 32. Alternatively or additionally, compression vector $(c_1, c_2, ..., c_n)$ is suitable for reducing the power of the adjusted voice signal S(t) to a level substantially equal to the original voice signal S(t) or to any other desired level.

Optionally, compression unit 94 determines for each frequency component the signal to noise ratio (SNR) in the frequency component. Optionally, if the SNR of the frequency component is greater than about 6dB, the compression gain of the vector $c_i$, is set to attenuate the voice signal in the band by an attenuation value (a negative gain) that is a function of the SNR. In some embodiments of the invention, the magnitude of the negative gain is in accordance with a monotonous function which has a value of 0dB (no attenuation) at an SNR of 6dB and has a value of 5dB when the SNR is about 24dB. Optionally, the maximal magnitude of the negative gain is 5dB. In an exemplary embodiment of the invention, the magnitude of the negative gain (Y) is in accordance with the following function:

$$Y = -2.95 \cdot 10^{-11} \cdot x^8 + 5.67 \cdot 10^{-9} \cdot x^7 - 4.43 \cdot 10^{-7} \cdot x^6 + 1.80 \cdot 10^{-5} \cdot x^5 - 4.0 \cdot 10^{-4} \cdot x^4 +$$

$$+ 0.0046 \cdot x^3 - 0.026 \cdot x^2 - 0.073 \cdot x + 4.92 \cdot 10^{-13}$$

in which x designates the SNR.

Alternatively or additionally, compression unit 94 searches for peak frequency components in which voice signal S(t), as represented by $\{ES_i\}$, has an amplitude substantially greater (e.g., by 8-10dB) than its neighbor frequency components or all the other frequency components. Optionally, compression vector $(c_1, c_2, ..., c_n)$ reduces the amplitude of the peak frequency components by about 5dB or by a percentage of the extent to which the amplitude of the peak frequency component is greater than the other frequency components.

Further alternatively or additionally, the compression vector $(c_1, c_2, ..., c_n)$ also attenuates frequency components which are masked by the noise. Optionally, frequency components in which the voice signal S(t), has an amplitude substantially lower (e.g., by at least 6 dB) than the noise, are multiplied by zero such that they are substantially eliminated.

Further alternatively or additionally, any other compression functions which do not substantially distort the output signal are used. Further alternatively or additionally, compression unit 94 is not used and limiter 100 is relied upon to perform the compression. Further alternatively or additionally, limiter 100 is not used and compression unit 94 is relied upon to perform the compression. Further alternatively, both limiter 100 and compression unit 94 are not used and no compression is performed. Optionally, in this alternative, power amplifier 52 has an operation range greater than the signal range of the input voice signal, so as to allow for amplifications of the input signal which can be sounded by speaker 32.

In some embodiments of the invention, the amplified power vector $\{Gain2 \times Gain1 \times ESM_i\}$ provided by formants unit 93 is smoothed by a pre-compression smoother 107 before it is provided to compression unit 94. Optionally, pre-compression smoother 107 performs the same or a similar smoothing function as pre-formats smoother 97. Alternatively to using smoother 107, compressor unit 94 receives the smoothed output of pre-formants smoother 97, optionally multiplied by Gain2, as representing voice signal S(t). In some embodiments of the invention, compression unit 94 uses smoothed noise power vector $\{EN_i'\}$ to represent noise signal N(t). Alternatively or additionally, compression unit 94 uses a different smoothed version of noise power vector $\{EN_i\}$. Further alternatively or additionally, compression unit 94 uses noise power vector $\{EN_i\}$, which is not smoothed.

In some embodiments of the invention, multiplier 99 receives the output factors, e.g., emphasis vector $\{p_i\}$, Gain1, Gain2 and compression vector $\{c_i\}$, and generates gain vector $(g_1, g_2, ..., g_n)$ as a product of the received values, e.g., $g_i = p_i*Gain1*Gain2*c_i$. Alternatively or additionally to logic unit 77 including multiplier 99, one or more of autogain unit 92, formants unit 93 and compression unit 94 receives the output factor of one or more previous units. In an exemplary embodiment of the invention, formants unit 93 receives Gain1 and provides a product of Gain1 and Gain2, and compression unit 94 receives the emphasis vector, Gain1 and Gain2, generates compression vector $(c_1, c_2, ..., c_n)$ and accordingly generates gain vector $(g_1, g_2, ..., g_n)$.

Alternatively or additionally to units 92, 93 and 94 operating on corrected versions of the power vector $\{ES_i\}$, one or more of the units operates on the original power vector $\{ES_i\}$ or on a partially corrected power vector.

In some embodiments of the invention, logic unit 77 includes a weight determination unit 138, which dynamically determines the weights $b_1$ and $b_2$ used by weighted average unit 133. Optionally, the weight $b_1$ given to the modified voice signal S"(t) is relatively high, i.e., greater than 0.5, when the background is relatively noisy, e.g., Gain1 is relatively high. Optionally, the weight $b_1$ given to the modified voice signal S"(t) is a non-decreasing function of Gain1. That is, as Gain1 increases, more weight is given to the modified voice signal S"(t). In an exemplary embodiment of the invention, weight $b_1$ = Gain1/max, wherein max is a maximal possible value of Gain1. Alternatively or additionally, when Gain1 is below a predetermined value, e.g., 0.3, weight $b_1$ is set to zero. Further alternatively or additionally, when Gain1 is above a predetermined value, e.g., 3, weight $b_1$ is set to one.

Alternatively, weights $b_1$ and $b_2$ are functions of the noise $\{EN_i\}$ or have predetermined values, e.g., 0.5. Alternatively or additionally, a user control allows the user to adjust the values of $b_1$ and $b_2$ according to the user's preference.

In some embodiments of the invention, $b_1$ and $b_2$ provided to weighted average unit 133 after passing through a low pass filter, which prevents frequent fluctuations in the weights. Alternatively or additionally, the function performed by weight determination unit 138 includes a time smoothing effect.

Fig. 4 is a schematic block diagram of auto-gain unit 92, in accordance with an embodiment of the present invention. Auto-gain unit 92 optionally comprises a signal history unit 406, which determines a representative typical power $H_s$ for voice signal S(t) as represented by modified power vector $\{ESM_i\}$. In addition, auto-gain unit 92 includes a noise history unit 411, which determines a representative typical power $H_n$ for noise signal N(t) as represented by noise power vector $\{EN_i\}$. The representative typical values are optionally calculated as an average of a plurality of maximums over different periods. In some embodiments of the invention, signal history unit 406 and noise history unit 411 are substantially identical. Alternatively, history unit 406 and noise history unit 411 are different from each other. For example, voice typical power $H_s$ may give higher wait to previous signals than given by the noise typical power $H_n$.

In some embodiments of the invention, each history unit 406 comprises an adder 408, which generates a sum of the powers of all the received powers of the frequency components. Alternatively, adder 408 generates a sum of the frequency component signals from filters 62 and calculates the power of the sum and/or calculates the power of the original signal S(t). The sum is optionally provided to a short term maximum register 410 and to a long terrn maximum register 412. In some embodiments of the invention, each of registers 410 and 412 determines its new value as follows. If the received value is greater than the internally stored value the new value equals the stored value. Otherwise, the new value equals a decayed version of the internally stored value, wherein the value in short term register 410 decays faster than the value in long term register 412. In some embodiments of the invention, the value in short term register 410 decays within the time of about a single word, such that the value in register 410 is related to a maximal power over a single word. In some embodiments of the invention, the value in long term register 412 decays within the time of a sentence or a few sentences, such that the value in register 412 is related to a maximal power over a relatively long period.

In some embodiments of the invention, registers 410 and 412 of history unit 406 have the same decay values as registers 410 and 412, respectively of history unit 411. Alternatively, registers 410 and 412 of history unit 406 have different decay values than the decay values of registers 410 and 412 of history unit 411. In an exemplary embodiment of the invention, the value in long term register 412 of signal history unit 406 decays to between about 10-30% of its value over a period of about 256 ms, while the value in short term register 410 of signal history unit 406 decays over a period of about 64 ms. Optionally, the value in long term register 412 of noise history unit 411 decays to between about 10-30% of its value over a period of about 1 second, while the value in short term register 410 of noise history unit 411 decays over a period of between about 25-100 ms.

In some embodiments of the invention, when VAD unit 250 provides an indication that the voice signal does not include speech, the values in registers 410 and 412 of signal history unit 406 do not decay. Optionally, when the voice signal does not include speech registers 410 are not updated even if the input value has a higher power than the contents of the register. Alternatively or additionally, the value in short term register 410 is zeroed responsive to the determination that the voice signal does not include speech. In some embodiments of the invention, a similar behavior is performed in noise history unit 411.

In some embodiments of the invention, instead of immediately updating the value in one or more of registers 410 and 412 if the received value is greater than the content of the register, the update is performed in stages, so as not to cause too sharp an update. Optionally, updates are limited to a predetermined slope steeper than the decay slope.

Alternatively to auto-gain unit 92 operating based on power signals $\{ESM_i\}$ and/or $\{EN_i\}$, auto-gain unit 92 operates based on the samples of the frequency components. Optionally, the values of the frequency components are added and their square is taken, and this square is used by auto-gain unit 92.

In some embodiments of the invention, an averaging unit 414 calculates an average of the values in short term register 410 and long term register 412, so as to generate the typical power value $H_s$ or $H_n$. In some embodiments of the invention, averaging unit 414 calculates a geometrical average. Alternatively, averaging unit 414 calculates any other average, such as an arithmetic average or a median. Optionally, auto-gain unit 92 further includes a divider 108 and a square root unit 109, which calculate the square root of the ratio of the history values, i.e., $\sqrt{H_n/H_s}$, so as to provide a gain value from the ratio of powers.

Alternatively to only registers 410 and 412, history unit 406 and/or 411 may include more registers with different decay times. Further alternatively or additionally, any other method may be used to determine one or more representative typical power values.

In some embodiments of the invention, auto-gain unit 92 includes a noise flatness unit 407 which provides a flatness (or density) indication value (FLAT) on the frequency spread of noise N(t). The amplification factor Gain1 optionally linearly increases with the flatness indication value, such that when the noise has a wider spectrum, the amplification is larger. Optionally, when noise N(t) is similar to white noise, Gain1 has a value close to 1, while when the noise is similar to a sine wave with a specific frequency, Gain1 has a low value, e.g., 0.2.

In some embodiments of the invention, noise flatness unit 407 calculates a normalized average NA of the frequency component noise power values $\{EN_i\}$. Optionally, the average is normalized by dividing by a maximum power value, i.e., $\max_i\{EN_i\}$. In an exemplary embodiment of the present invention, the flatness indication FLAT is calculated from the normalized average NA according to the following equation:

$$FLAT = \begin{cases} NA/2 & NA < 0.5 \\ 1 - (NA - 0.5)/2 & NA \geq 0.5 \end{cases}$$

In some embodiments of the invention, the flatness indication FLAT is averaged in time with previous values of FLAT, in order to prevent strong fluctuations in its value. Optionally, the flatness indication is filtered using a first or second degree low pass filter with previous time values. Alternatively or additionally, any other suitable time dependent filter may be used to prevent strong fluctuations.

Optionally, a multiplier 405 generates Gain1 as the product of the noise flatness indication FLAT, the square root of the ratio of the history values $\sqrt{H_n/H_s}$ and a predetermined constant amplification (min_gain). In some embodiments of the invention, the predetermined constant amplification (min_gain) is about 1. Alternatively, the predetermined constant amplification (min_gain) is between about 2-2.5.

Figs. 5A and 5B show graphs of an exemplary voice signal 209 before and after correction by a gain generated by a formants unit 93, in accordance with an embodiment of the present invention. Optionally, formants unit 93 identifies up to a predetermined number (e.g., three) of formants, i.e., envelope peaks, of voice signal S(t). Selecting up to the predetermined number of formants optionally comprises beginning from the lower frequency bands and selecting until no more formants are found or until the predetermined number of formants were found. In an exemplary embodiment of the invention, formants unit 93 identifies the frequency components in which the formants are located, based on power signals $\{ESM_i\}$. For example, in signal 209, formants unit 93 identifies frequency component 3 (S3), frequency component 8 (S8) and frequency component 12 (S12), as including the three first formants.

For each of the frequency components in which the predetermined number of formants are located, formants unit 93 optionally determines the SNR in the frequency component, i.e., the difference between the power of the noise signal $EN_i$ 208 in the frequency component and the power of the voice signal ESMi 209 in the frequency component. Optionally, formants unit 93 selects the frequency component in which the SNR is smallest (including most negative). For signal 209, the SNR of frequency component 8 is the smallest. In some embodiments of the invention, the output gain (Gain2) of formants unit 93 is equal to a gain required to bring the smallest SNR to a predetermined value, for example, between about 3-6dB. Alternatively or additionally, the output gain (Gain2) of formants unit 93 brings the SNR to a dynamically adjusted level. Optionally, the dynamically adjusted level is adjusted responsive to the level of the noise, the level of voice signal S(t) and/or responsive to the value of Gain1. Optionally, the output gain (Gain2) is calculated by taking the square root of the ratio of the noise and signal power ratios and multiplying by a constant margin between about 2-4 (equivalent to 3-6dB).

After multiplying signal 209 by Gain2, the spectrum of signal 209 will be as shown in Fig. 5B. Optionally, if the lowest SNR is above a predetermined threshold, e.g., between 3-6dB, Gain2 is set to 1. In an exemplary embodiment of the invention, the predetermined threshold is equal to the level to which Gain2 brings the lowest SNR if amplification is required. Alternatively, the predetermined threshold is different from the level to which Gain2 brings the lowest SNR if amplification is required, for example the predetermined threshold may be lower. Using a lower predetermined threshold limits the cases of amplitude changes performed, to those cases in which the changes are really required.

In some embodiments of the invention, the predetermined number of formants includes fewer than the number of formants in voice signal S(t). Optionally, the predetermined number of formants comprises between 2-4, possibly three. It is noted that a voice signal S(t) may have fewer than the predetermined number of formants. In such a case, the determination of the lowest SNR is performed from among the formants found, although fewer than the predetermined number of formants were found.

It is noted that formants unit 93 may be used in some embodiments even when system 30 works with audio signals that do not include speech, such as music signals.

Fig. 6 is a schematic graph of a gain of enhance filter 112, in accordance with an embodiment of the present invention. Optionally, as shown, low and high frequencies are attenuated by enhance filter 112, while central frequencies are amplified. In some embodiments of the invention, the total power of voice signal S(t) is not changed by enhance filter 112. Optionally, enhance filter 112 comprises a multiplier with a respective gain for each frequency component $S_i$ (t). Alternatively, at least one group of a plurality of frequency components are multiplied by a single gain factor of enhance filter 112.

Alternatively to enhance filter 112 having the gain described in Fig. 6, the gain of enhancement filter 112 is in

EP 1 312 162 B1

accordance with any other function which enhances speech signals and/or reduces noise. In some embodiments of the invention, the gain of enhancement filter 112 is determined based on simulations. Alternatively or additionally, the gain of enhancement filter 112 is adjusted during factory calibration. Further alternatively or additionally, the gain of enhancement filter 112 is periodically updated responsive to field tests. Further alternatively or additionally, the gain of enhancement filter 112 is adjusted by the user. This alternative is especially useful for hearing impaired.

Fig. 7 is a schematic graph of an exemplary noise power signal spectrum 122 and a masked noise power signal spectrum 123, in accordance with an embodiment of the present invention. Masking unit 119 optionally finds spectral peaks 251 of signal spectrum 122 and calculates for each peak 251 a pair of lines 301 and 302 which descend from the peak in opposite directions, with a predetermined slope. Optionally, the predetermined slope is between about 40-60 dB / decade. Alternatively or additionally, the lines 301 and 302 from different peaks 251 have different slopes, according to acoustical considerations. Further alternatively or additionally, lines 301 and 302 have different slopes for a same peak, for example according to acoustic considerations. Masked noise power signal spectrum 123 optionally is equal, at each point, to the maximal value of the lines 301 and 302 at the point. Alternatively, masked noise power signal spectrum 123 optionally is equal, at each point, to the maximal value of the lines 301 and 302 and of spectrum 122 at the point. Optionally, masking unit 119 operates in real time, providing for each frequency component a masked value, instead of the original noise power value.

Alternatively, any other masking unit which takes into account the inter-effect of frequencies on the human ear, is used. Further alternatively, masking unit 119 is not used, for example when the number of frequency components is relatively low and/or filters 64 as shown in Fig. 2B are used in generating the frequency component values. When filters 64 are used in generating the frequency component values, the structure of the filters generally can be designed to perform the masking task.

In some embodiments of the invention, for example in which microphone 34 and speaker 32 belong to a telephone, system 30 comprises a speech detector which determines when the user of the telephone is talking. Optionally, when the user is talking, system 30 is disabled from correcting the remote voice signal S(t). Thus, system 30 does not relate to the user's talking as noise and hence does not force the amplitude of the remotely received voice signal above the user's talking sounds.

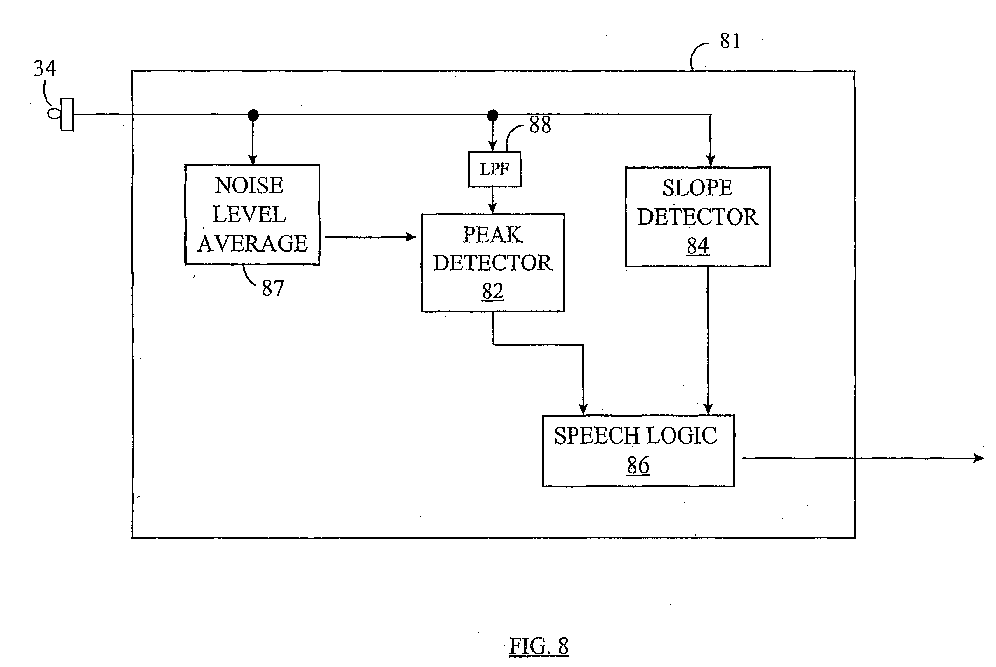

Fig. 8 is a schematic block diagram of a speech detector 81, in accordance with an embodiment of the present invention. Speech detector 81 optionally receives the signals from microphone 34, and determines when the received signals include speech sounds. In some embodiments of the invention, speech detector 81 comprises a peak detector 82 and/or a slope detector 84, which determine when the received signals include speech signals. Optionally, peak detector 82 compares the received signal to a threshold and provides a speech indication when the received signal is above the threshold. Slope detector 84 optionally follows the slope of the amplitude of the received signals. In some embodiments of the invention, slope detector 84 provides a speech start indication when the slope is beyond a predetermined increasing slope and a speech end indication when the slope is beyond a predetermined decreasing slope.

Optionally, a speech logic unit 86 receives the indications. In some embodiments of the invention, when both a speech start indication and a speech indication are received, logic unit 86 disables the signal correction of system 30. Optionally, when a speech end indication is received and a speech indication is not received, logic unit 86 begins a count period, of about between 0.5- 1.2 seconds, optionally 1 second, after which the signal correction of system 30 is enabled. The signal correction of system 30 is optionally enabled only if a speech start indication together with a speech indication are not received during the count period. Thus, when the user is talking, the voice signal S(t) from the remote party is not enhanced to overcome the user's talk.

In some embodiments of the invention, disabling the signal correction by system 30 comprises setting the VAD signal of the remote voice signal S(t) to no speech, regardless of whether the remote voice signal S(t) actually includes speech signals. Alternatively or additionally, disabling the signal correction by system 30 comprises setting $b_1$ to zero.

In some embodiments of the invention, the threshold used by peak detector 82 is adjusted adaptively responsive to measurements of the received signal when there is no speech. Optionally, a noise averaging unit 87 averages the amplitude of the received signal during a recent period in which logic unit 86 determined that the received signal from microphone 34 does not include speech. In some embodiments of the invention, the averaging is performed by an integrator. The threshold used by peak detector 82 is optionally a predetermined gap above the average noise level from noise averaging unit 87. The use of an adaptive threshold is advantageous for cases in which users speak louder when the surrounding noise is high and speak lower when the noise is low.

In some embodiments of the invention, the signal entering peak detector 82 is passed through a low pass filter (LPF) 88, so as to prevent transient changes in the received signal from affecting the output of logic unit 86. Alternatively or additionally, the signals entering peak detector 82 and/or slope detector 84 are passed through a hysteresis function to prevent transient signals from affecting the output.

In some embodiments of the invention, the predetermined increasing and decreasing slopes have the same magnitude, e.g., about 0.5*Max_amplitude / 200 msec, wherein Max_amplitude is a predetermined maximal value of speech signals received by microphone 34 or a maximal amplitude for a current speaker. Alternatively or additionally, the predetermined increasing and decreasing slopes have different magnitudes.

Alternatively or additionally to using speech detector 81, any other speech detector or VAD may be used, such as a detector similar to VAD 250 and/or as described in the above mentioned U.S. patent 5,524,148. Further alternatively or additionally, speech detector 81 or a variation thereof may be used instead of VAD 250. Further alternatively, speech detector 81 is not used. When speaker 32 is located adjacent microphone 34, this alternative may cause system 30 to compensate for the user's talk, so that the received signals are enhanced even when the user talks.

In the above described embodiments, system 30 was described as having seven units, namely enhancement unit 91, auto-gain unit 92, formants unit 93, compression unit 94, limiter 100, enhancement filter 112 and weight determination unit 138, which affect voice signal S(t), either directly or indirectly by calculating a gain for the voice signal S(t). It is noted that in some embodiments of the invention, enhancement unit 91, enhancement filter 112 and limiter 100 operate irrespective of the input noise, while auto-gain unit 92, weight determination unit 138, formants unit 93 and compression unit 94 provide gain values which depend on the noise.

Thus, in these embodiments of the invention, units which change voice signal S(t) responsive to the input noise either change the entire voice signal S(t) with the same gain (e.g., units 92 and 93) or do not cause the relative positions of the peaks of the voice signal to change (e.g., unit 94). Hence, the noise dependent corrections do not cause signal distortion. In some embodiments of the invention, compression unit 94 is not used, and therefore, all the noise dependent corrections amplify substantially the entire signal with the same gain.

Generally, units 92 and 93 determine gain factors, enhancement unit 91 and enhancement filter 112 perform predistortion which is independent of the input noise and compression unit 94, limiter 100 and weight determination unit 138 save energy.

Alternatively to the gain $\{g_i\}$ of multiplication unit 117 including both noise dependent and noise independent factors, in some embodiments of the invention, the gain of multiplication unit 117 includes only noise dependent factors. Noise independent factors, such as generated by enhancement unit 91 are optionally applied by enhancement filter 112 and/or by a separate multiplier. Alternatively or additionally, enhancement unit 91 is not used. In some embodiments of the invention, for example in which compression unit 94 is not used, the gain of multiplication unit 117 is the same for substantially all the frequency components.

In some embodiments of the invention, the noise compensation of the present invention is combined with active noise suppression methods. Optionally, the noise estimate used in correcting the voice signal S(t) in accordance with embodiments of the present invention, is based on the actively suppressed noise. Alternatively, the noise estimate is based on the original noise before correction.

It is noted that the above described embodiments may be implemented using, hardware, software or a combination thereof. The processing may include digital processing, analog processing or a combination thereof. Particularly, the filters described above may be analog or digital filters.

It will be appreciated that the above described methods may be varied in many ways, including, performing a plurality of steps concurrently, changing the order of steps and changing the exact implementation used. For example, when an FFT is used to generate the frequency component values, the values of a few adjacent FFT values may be added to generate frequency component values of a smaller number of frequency components. It should also be appreciated that the above described description of methods and apparatus are to be interpreted as including apparatus for carrying out the methods and methods of using the apparatus.

## Claims

1. A method of processing an audio signal in order to overcome background noise extraneous to the audio signal, comprising:

   comparing a measure of the audio signal in a frequency component of the audio signal to a measure of the noise in a frequency component of the background noise;
   determining a gain responsive to the comparison; and
   amplifying at least a portion of the audio signal, including at least one frequency segment not included in the frequency component of the audio signal, by the determined gain.

2. A method according to claim 1, wherein the measure of the audio signal comprises a power of the audio signal.

3. A method according to claim 1 or claim 2, wherein the measure of the noise in the frequency component of the background noise comprises a power of a masking version of the noise.

**4.** A method according to any of the preceding claims, wherein amplifying the at least a portion of the signal comprises amplifying a portion including the compared frequency component of the audio signal.

**5.** A method according to claim 4, wherein amplifying the at least a portion of the signal comprises amplifying the entire audio signal by the determined gain.

**6.** A method according to any of the preceding claims, wherein determining the gain to be applied comprises determining a gain which would bring the signal to noise ratio in the frequency band of the frequency component of the audio signal to above a threshold value.

**7.** A method according to claim 6, wherein the threshold value is dynamically adjusted as the signal and/or noise measure changes in time.

**8.** A method according to claim 6, wherein the threshold value is a predetermined value.

**9.** A method according to any of the preceding claims, wherein comparing a measure of the audio signal in a frequency component of the audio signal comprises comparing in a frequency component which includes a formant of the audio signal.

**10.** A method according to claim 9, wherein comparing in a frequency component which includes a formant of the audio signal comprises comparing in a frequency component of a frequency band with a lowest signal to noise ratio (SNR) among a plurality of frequency components of the audio signal.

**11.** A method according to any of the preceding claims, comprising dividing the audio signal into a plurality of frequency components and selecting fewer than all the frequency components.

**12.** A method according to claim 11, wherein selecting fewer than all the frequency components comprises selecting frequency components including formants of the audio signal.

**13.** A method according to claim 12, wherein selecting frequency components including formants of the audio signal comprises selecting up to a predetermined number of frequency components including formants.

**14.** A method according to any of claims 11-13, comprising choosing the frequency component of the audio signal, from the selected frequency components.

**15.** A method according to any of the preceding claims, wherein amplafying the at least a portion of the audio signal comprises amplifying by a gain combined from a plurality of gains including the gain determined responsive to the comparison.

**16.** A method according to any of the preceding claims, comprising sounding the amplified signal in the presence of the background noise.

**17.** A method according to any of the preceding claims, wherein the frequency component of the audio signal and the frequency component of the noise span over substantially the same frequency band.

**18.** A method according to any of the preceding claims, wherein the frequency component of the audio signal comprises a band of frequencies.

**19.** A noise compensation system, comprising:

an input interface adapted to receive an audio signal;
a speaker adapted to sound an enhanced audio signal;
a microphone adapted to collect background noise, that may interfere with a listener listening to the enhanced signal; and
a controller adapted to compare a measure of the audio signal in a frequency component of the audio signal to a measure of the background noise in the same frequency component, determine a gain responsive to the comparison and amplify at least a portion of the audio signal, including at least one segment not in the frequency component, by the determined gain, so as to provide the enhanced audio signal.

**20.** A system according to claim 19, wherein the speaker and microphone are part of a telephone hand-set.

**21.** A system according to claim 19 or claim 20, comprising an echo canceller which removes at least one echo of the enhanced audio signal from the background noise.

**22.** A system according to claim 21, wherein the echo canceller removes only a single echo of the enhanced audio signal from the background noise.

**Patentansprüche**

**1.** Verfahren zum Verarbeiten eines Audiosignals, um Hintergrundgeräusche zu überwinden, die nicht zum Audiosignal gehören, umfassend:

Vergleichen eines Maßes des Audiosignals in einer Frequenzkomponente des Audiosignals mit einem Maß des Geräuschs in einer Frequenzkomponente des Hintergrundgeräuschs;
Bestimmen einer Verstärkung, ansprechend auf den Vergleich; und
Verstärken von mindestens einem Teil des Audiosignals, umfassend mindestens ein Frequenzsegment, das nicht in der Frequenzkomponente des Audiosignals enthalten ist, durch die bestimmte Verstärkung.

**2.** Verfahren nach Anspruch 1, bei dem das Maß des Audiosignals eine Leistung des Audiosignals umfasst.

**3.** Verfahren nach Anspruch 1 oder Anspruch 2, bei dem das Maß des Geräuschs in der Frequenzkomponente des Hintergrundgeräuschs eine Leistung einer Überdeckungsversion des Geräuschs umfasst.

**4.** Verfahren nach einem der vorangehenden Ansprüche, bei dem ein Verstärken des mindestens einen Teils des Signals ein Verstärken eines Teils umfasst, der die verglichene Frequenzkomponente des Audiosignals enthält.

**5.** Verfahren nach Anspruch 4, bei dem ein Verstärken des mindestens einen Teils des Signals ein Verstärken des ganzen Audiosignals um die bestimmte Verstärkung umfasst.

**6.** Verfahren nach einem der vorangehenden Ansprüche, bei dem ein Bestimmen der anzuwendenden Verstärkung ein Bestimmen einer Verstärkung umfasst, die den Störabstand im Frequenzband der Frequenzkomponente des Audiosignals bis zu über einen Schwellwert bringen würde.

**7.** Verfahren nach Anspruch 6, bei dem der Schwellwert dynamisch eingestellt wird, wenn sich das Signal- und/oder Geräuschmaß mit der Zeit ändert.

**8.** Verfahren nach Anspruch 6, bei dem der Schwellwert ein vorbestimmter Wert ist.

**9.** Verfahren nach einem der vorangehenden Ansprüche, bei dem ein Vergleichen eines Maßes des Audiosignals in einer Frequenzkomponente des Audiosignals ein Vergleichen in einer Frequenzkomponente umfasst, die einen Formanten des Audiosignals enthält.

**10.** Verfahren nach Anspruch 9, bei dem ein Vergleichen in einer Frequenzkomponente, die einen Formanten des Audiosignals enthält, ein Vergleichen in einer Frequenzkomponente eines Frequenzbands mit einem geringsten Störabstand (SNR) unter einer Mehrzahl von Frequenzkomponenten des Audiosignals umfasst.

**11.** Verfahren nach einem der vorangehenden Ansprüche, umfassend ein Aufteilen des Audiosignals in eine Mehrzahl von Frequenzkomponenten und Auswählen von weniger als sämtlichen Frequenzkomponenten.

**12.** Verfahren nach Anspruch 11, bei dem ein Auswählen von weniger als sämtlichen Frequenzkomponenten ein Auswählen von Frequenzkomponenten, die Formanten des Audiosignals enthalten, umfasst.

**13.** Verfahren nach Anspruch 12, bei dem ein Auswählen von Frequenzkomponenten, die Formanten des Audiosignals enthalten, ein Auswählen bis zu einer vorbestimmten Anzahl von Frequenzkomponenten, die Formanten enthalten, umfasst.

**14.** Verfahren nach einem der Ansprüche 11-13, umfassend ein Wählen der Frequenzkomponente des Audiosignals aus den ausgewählten Frequenzkomponenten.

**15.** Verfahren nach einem der vorangehenden Ansprüche, bei dem ein Verstärken des mindestens einen Teils des Audiosignals ein Verstärken um eine Verstärkung umfasst, die aus einer Mehrzahl von Verstärkungen kombiniert wird, einschließlich der Verstärkung, die ansprechend auf den Vergleich bestimmt wird.

**16.** Verfahren nach einem der vorangehenden Ansprüche, umfassend ein Ertönen lassen des verstärkten Signals in der Anwesenheit des Hintergrundgeräuschs.

**17.** Verfahren nach einem der vorangehenden Ansprüche, bei dem die Frequenzkomponente des Audiosignals und die Frequenzkomponente des Geräuschs im Wesentlichen dasselbe Frequenzband überspannen.

**18.** Verfahren nach einem der vorangehenden Ansprüche, bei dem die Frequenzkomponente des Audiosignals ein Band von Frequenzen umfasst.

**19.** Geräuschkompensationssystem, umfassend:

eine Eingangsschnittstelle, die angepasst ist, um ein Audiosignal zu empfangen;
einen Lautsprecher, der angepasst ist, um ein verbessertes Audiosignal ertönen zu lassen;
ein Mikrofon, das angepasst ist, um Hintergrundgeräusch einzufangen, das einen Hörer beeinträchtigen kann, der dem verbesserten Signal lauscht; und
einen Kontroller, der angepasst ist, um ein Maß des Audiosignals in einer Frequenzkomponente des Audiosignals mit einem Maß des Hintergrundgeräuschs in derselben Frequenzkomponente zu vergleichen, ein Verstärkung ansprechend auf den Vergleich zu bestimmen und mindestens einen Teil des Audiosignals, einschließlich mindestens eines Segments, das sich nicht in der Frequenzkomponente befindet, um die bestimmte Verstärkung zu verstärken, um das verbesserte Audiosignal bereitzustellen.

**20.** System nach Anspruch 19, bei dem der Lautsprecher und das Mikrofon Teil eines Telefonhandapparats sind.

**21.** System nach Anspruch 19 oder Anspruch 20, umfassend einen Echokompensator, der mindestens ein Echo des verbesserten Audiosignals aus dem Hintergrundgeräusch entfernt.

**22.** System nach Anspruch 21, bei dem der Echoausgleichvorrichtung nur ein einziges Echo des verbesserten Audiosignals aus dem Hintergrundgeräusch entfernt.


**Revendications**

**1.** Procédé de traitement d'un signal audio afin de surmonter le problème d'un bruit de fond qui n'a aucun rapport avec le signal audio, comportant les étapes consistant à :

comparer une mesure du signal audio dans une composante de fréquence du signal audio à une mesure du bruit dans une composante de fréquence du bruit de fond,
déterminer un gain en réponse à la comparaison, et
amplifier au moins une partie du signal audio, incluant au moins un segment de fréquence non-inclus dans la composante de fréquence du signal audio, par l'intermédiaire du gain déterminé.

**2.** Procédé selon la revendication 1, dans lequel la mesure du signal audio comporte une puissance du signal audio.

**3.** Procédé selon la revendication 1 ou la revendication 2, dans lequel la mesure du bruit dans la composante de fréquence du bruit de fond comporte une puissance d'une version de masquage du bruit.

**4.** Procédé selon l'une quelconque des revendications précédentes, dans lequel l'amplification d'au moins une partie du signal comporte l'amplification d'une partie incluant la composante de fréquence comparée du signal audio.

**5.** Procédé selon la revendication 4, dans lequel l'amplification d'au moins une partie du signal comporte l'amplification du signal audio entier par l'intermédiaire du gain déterminé.

**6.** Procédé selon l'une quelconque des revendications précédentes, dans lequel la détermination du gain à appliquer comporte la détermination d'un gain qui va amener le rapport signal sur bruit dans la bande de fréquence de la composante de fréquence du signal audio au-dessus d'une valeur de seuil.

**7.** Procédé selon la revendication 6, dans lequel la valeur de seuil est dynamiquement ajustée lorsque la mesure du signal et/ou du bruit change dans le temps.

**8.** Procédé selon la revendication 6, dans lequel la valeur de seuil est une valeur prédéterminée.

**9.** Procédé selon l'une quelconque des revendications précédentes, dans lequel la comparaison d'une mesure du signal audio dans une composante de fréquence du signal audio comporte la comparaison dans une composante de fréquence qui inclut un formant du signal audio.

**10.** Procédé selon la revendication 9, dans lequel la comparaison d'une composante de fréquence qui inclut un formant du signal audio comporte la comparaison dans une composante de fréquence d'une bande de fréquence ayant un rapport signal sur bruit le plus faible parmi une pluralité de composantes de fréquence du signal audio.

**11.** Procédé selon l'une quelconque des revendications précédentes, comportant la division du signal audio en une pluralité de composantes de fréquence et la sélection d'un nombre de composantes de fréquence inférieur à la totalité de celles-ci.

**12.** Procédé selon la revendication 11, dans lequel la sélection d'un nombre de composantes de fréquence inférieur à la totalité de celles-ci comporte la sélection des composantes de fréquence incluant des formants du signal audio.

**13.** Procédé selon la revendication 12, dans lequel la sélection des composantes de fréquence incluant des formants du signal audio comporte la sélection jusqu'à un nombre prédéterminé de composantes de fréquence incluant des formants.

**14.** Procédé selon l'une quelconque des revendications 11 à 13, impliquant de choisir la composante de fréquence du signal audio, parmi les composantes de fréquence sélectionnées.

**15.** Procédé selon l'une quelconque des revendications précédentes, dans lequel l'amplification d'au moins une partie du signal audio comporte l'amplification par l'intermédiaire d'un gain combiné parmi une pluralité de gains incluant le gain déterminé en réponse à la comparaison.

**16.** Procédé selon l'une quelconque des revendications précédentes, comportant l'émission du signal amplifié en présence du bruit de fond.

**17.** Procédé selon l'une quelconque des revendications précédentes, dans lequel la composante de fréquence du signal audio et la composante de fréquente du bruit recouvrent en grande partie la même bande de fréquence.

**18.** Procédé selon l'une quelconque des revendications précédentes, dans lequel la composante de fréquence du signal audio comporte une bande de fréquence.

**19.** Système de compensation de bruit, comportant :

une interface d'entrée adaptée pour recevoir un signal audio,
un haut-parleur adapté pour émettre un signal audio amélioré,
un microphone adapté pour collecter un bruit de fond, qui peut interférer avec une personne écoutant le signal amélioré, et
un contrôleur adapté pour comparer une mesure du signal audio dans une composante de fréquence du signal audio à une mesure du bruit de fond dans la même composante de fréquence, déterminer un gain en réponse à la comparaison et amplifier au moins une partie du signal audio, incluant au moins un segment n'étant pas dans la composante de fréquence, par l'intermédiaire du gain déterminé, de manière à délivrer le signal audio amélioré.

**20.** Système selon la revendication 19, dans lequel le haut-parleur et le microphone font partie d'un combiné téléphonique.

**21.** Système selon la revendication 19 ou la revendication 20, comportant un atténuateur d'écho qui supprime au moins un écho du signal audio amélioré du bruit de fond.

**22.** Système selon la revendication 21, dans lequel l'atténuateur d'écho supprime uniquement un écho unique du signal audio amélioré du bruit de fond.

N(t)

S'(t)

32

CONTROLLER

40

S(t)

34

36

NOISE
CLEANER

95

Sinput(t) →

EC

96

30

FIG. 1

FIG. 2A

EP 1 312 162 B1

FIG. 2B

EP 1 312 162 B1

FIG. 3

FIG. 4

EP 1 312 162 B1

FIG. 5A

EP 1 312 162 B1

FIG. 5B

FIG. 6

EP 1 312 162 B1

FFT |POWER|

f

FIG. 7

FIG. 8